# EUROPEAN PATENT SPECIFICATION

(11) **EP 0 723 158 B1**
(45) Date of publication and mention of the grant of the patent: **03.12.2003**
(21) Application number: 96300361.1
(22) Date of filing: 18.01.1996
(51) Int. Cl.: G01R 15/12

(54) **Multimeter with an erroneous input prevention mechanism**
Multimeter mit Mechanismus zur Verhinderung falscher Eingangssignale
Multimètre avec mécanisme de prévention d'un signal d'entrée erroné

(30) Priority: 19.01.1995 JP 667295; 18.12.1995 JP 32934795
(43) Date of publication of application: 24.07.1996
(73) Proprietor: SEIKO EPSON CORPORATION, Tokyo 163 (JP)
(72) Inventor: Kamiya, Manabu, Suwa-shi, Nagano-ken, 392 (JP)
(74) Representative: Sturt, Clifford Mark

(56) References cited:
- EP-A- 0 474 086
- EP-A- 0 507 126

## Description

The present invention relates to a multimeter with an erroneous input prevention mechanism with a shutter board, in particular, it relates to a driving mechanism for the shutter board. Moreover, the present invention relates to a positional structure of the input terminal in which a test lead is plugged in a multimeter with an erroneous input prevention mechanism.

In a multimeter capable of measuring voltage and electric current, in addition to a negative common terminal hole and a positive input terminal hole, a separate input terminal hole is provided for measuring resistance value. In such a multimeter, all that is required is to plug a test lead pin plug into the appropriate input terminal hole corresponding to measurement mode and range selected by the switching of a rotary switch, but if a measurement is taken with the pin plug being plugged into the input terminal hole for measurement of a small current while the rotary switch is set for a large current range, for example, an internal circuit may be damaged.

EP 0474086A describes a multimeter having a plurality of input connections which are coupled to the measuring circuits by a multi-position measurement range switch. The multimeter described is provided with a disabling device, in the form of a shutter plate, which is mechanically linked to the measurement range switch, for selectively disabling the input connections. The shutter plate is linked to the measurement range switch by way of a stud-like element which engages in a groove provided between two arms of a coupling element arranged between the shutter plate and the measurement range switch. If a selected rotary angle of the measurement range switch in a first rotary direction is exceeded, the stud-like element slides out of the groove and releases the rigid coupling between the two parts. It is then possible to further rotate the measurement range switch and optionally set the multimeter to other measurement ranges associated with a measurement variable being measured without further movement of the shutter plate. If the measurement range switch is then rotated in the opposite rotary direction the stud-like element re-engages the slot to re-establish the rigid coupling between the parts are again impart movement to the shutter plate.

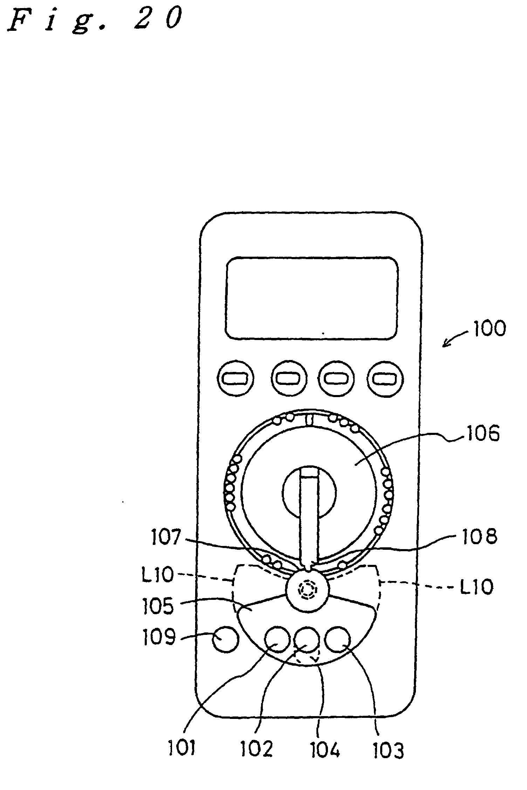

Japanese Laid-Open Patent Publication Hei 4-233473 proposes a multimeter with an erroneous input prevention mechanism. In this multimeter a shutter board 105 is provided with a hole 104 being formed for the first to third input terminal holes 101, 102, 103, as shown in Figure 20. In between the shutter board 105 and the rotary switch 106, a stud 107 which rotates with the rotary switch 106 as one unit engages with the fork-shaped teeth 108 of the shutter board 105 so that each time the rotary switch 106 rotates the shutter board 105 also rotates, causing the hole 104 to match one of the first to third input terminal holes 101, 102, 103. Hence, if the second input terminal hole 102 is in open state corresponding to setting of rotary switch 106, the first and the third input terminal hole 101, 103 are in interrupted state, making it impossible for the pin plug of test lead to be accidentally plugged into other holes than the second input terminal hole 102. Here, the negative common terminal hole 109 is positioned outside of the range of rotation (designated by dotted line L10) of the shutter board 105 and it is always in open state.

However, the multimeter with an erroneous input prevention mechanism 100 as shown in Figure 20 has the following problems.

To begin with, in many cases a multimeter is capable of coping with more than one measurement mode using one input terminal hole as far as the internal circuit is concerned, hence in the conventional multimeter 100, the first input terminal hole 101 is left in the open state because the shutter board 105 does not rotate further even if the rotary switch 106 is turned, once the stud 107 disengages from the fork-shape teeth 108 of the shutter board 105. However, the conventional multimeter 100 is designed to utilize disengagement of the stud 107 from the fork-shape teeth 108, hence a problem of limited design freedom arises. For example, only the first and the third input terminal holes 101, 103, which are located at the outside of the three input terminal hole group, can be assigned more than one mode but the second input terminal hole 102 cannot be assigned such plural modes.

Moreover, the multimeter 100 shown in Figure 20 is restricted in the sense that in order to leave the negative common terminal hole 109 always in the open state, the negative common terminal hole 109 must be formed at a location far away from the rotational range of the shutter board 105. Hence, there is little design freedom in terms of size and the range of rotation of the shutter board, which is a problem. Moreover, this creates another problem in that the multimeter cannot be miniaturized due to the requirement that the negative common terminal hole 109 be located far away from the range of the rotation of the shutter board 105.

Moreover, the multimeter 100 shown in Figure 20 is structured in such a manner that the input terminal hole is selected to be in the open state only by the hole 104 of the shutter board 105, causing each input terminal hole to be arranged on the locus of the hole, which is a restriction. Hence, there is little degree of freedom in changing the position of input terminal hole, creating additional problem that the usage and design become restricted.

Considering the problems described above, the present invention aims to provide a multimeter with an erroneous input prevention mechanism that increases the degree of design freedom by enabling assignment of more than one mode to the input terminal hole located in the middle of the plurality of input terminal holes selected by the rotary switch while providing an erroneous input prevention mechanism.

The present invention also aims to provide a multimeter with an erroneous input prevention mechanism that increases the degree of design freedom by easing restrictions on the size and the range of the rotation of the shutter board by the enabling placement of the common terminal hole even in the range of the rotation of the shutter board while providing an erroneous input prevention mechanism, and that is capable of miniaturization by the amount saved by placing the common terminal hole within range of the rotation of the shutter board.

The present invention further aims to provide a multimeter with an erroneous input prevention mechanism capable of improving usability and design characteristics through increasing the degree of freedom as a result of easing restrictions against the location of terminal hole formation by altering the method of opening and closing the terminal hole with the shutter board.

In order to resolve the above-stated problems, the present invention provides a multimeter with an erroneous input prevention mechanism comprising a rotary switch for rotation in a clockwise or counter-clockwise direction to select a measuring function, a common terminal hole to plug in a test lead pin plug, a plurality of selection holes separate from the common terminal hole, a shutter board rotating in predetermined range of angles based on the rotation operation of the rotary switch while leaving the common terminal hole in the open state and opening one of the selection terminal holes out of the plurality of selection terminal holes while interrupting other selection holes, and a shutter board driving mechanism to drive the rotation of the shutter board by transmitting rotational motion from the rotary switch to the shutter board, characterised in that the shutter board driving mechanism is provided, for rotational operation of the rotary switch in each of the clockwise or counter-clockwise directions, with at least two connection positions within the range of rotation of the rotary switch to mechanically connect the shutter board and the rotary switch, thereby interlocking rotation of the shutter board with rotation of the rotary switch, and is further provided with interrupting positions between the connection positions to interrupt the mechanical connection of the shutter board and rotary switch while keeping the shutter board stopped regardless of the rotation of the rotary switch.

With such a structure, when a measurement mode or range is selected by the switching of the rotary switch, only the selection terminal hole best fitting for the condition becomes the open state, hence the pin plug of the test lead is not accidentally plugged into another selection terminal hole. Therefore, no erroneous input occurs for the multimeter, preventing the failure of the multimeter, which is safe for the user. Moreover, with the rotation of rotary switch, the shutter board becomes connected mechanically to the rotary switch, the connection becomes interrupted, and again becomes connected mechanically to the rotary switch. Hence, more than one mode can be assigned, in practice, to the input terminal hole located at the central section among all the input terminal holes selected by the rotary switch, resulting in a high degree of design freedom.

In the present invention, a mechanism can be used as the shutter board driving mechanism wherein at least two drive-side protrusions separated by a predetermined angle range to transmit the rotational motion of the rotary switch to the shutter board by rotating the shutter board with the rotary switch as one unit, and the position of the connection position, and, in this case the interrupting position are defined by the location of drive-side protrusions being formed.

Moreover, a mechanism can be used as the driving power transmission mechanism between the shutter board and the drive-side protrusions having a slave member with slave-side protrusions to receive rotational driving power from the drive-side protrusions, and, in this case the slave member transmits the rotational driving power to the shutter board through the slave-side protrusions.

With such a structure, the selection terminal hole remains in the open state even if the rotary switch is rotated as long as the drive-side protrusions do not push away the slave-side protrusions. Thus, in structuring a multimeter in such a manner that the one selection terminal hole possesses more than one function, a complex mechanism is not needed, making the multimeter both compact and multi-functional.

In the present invention, the drive-side protrusions may preferably be formed in a selector member which is freely interchangeable on the rotary switch.

In this manner, the corresponding relationship between operation of the rotary switch and the opening and closing of selection terminal hole by shutter board can be easily altered by simply interchanging the selector member on which the drive-side protrusion is formed at a separate location.

In the present invention the shutter board may be structured to rotate with the center of rotation at the position where the common terminal hole is formed.

Even in the structure described above, only the selection terminal hole best fitting for the condition becomes the open state, hence the pin plug of the test lead is not accidentally plugged into other selection terminal hole. Therefore, no erroneous input occurs for the multimeter, preventing the failure of the multimeter, which is safe for the user. Moreover, the shutter board rotates with the center at the common terminal hole which is always left in the open state, hence the common terminal hole need not be formed at the location outside of the range of the rotation of the shutter board. Hence, the degree of design freedom increases by the amount of easing restriction on the size and the range of the rotation of the shutter board. Furthermore, miniaturization by the amount equivalent of placing the common terminal hole within range of the rotation is achieved.

With the present invention, the plurality of selection terminal holes may preferably be provided with a first and second selection terminal holes formed at two locations in substantially the same angular direction but different radial distances from the common terminal hole, the first selection terminal hole becomes open state by matching of a hole formed on the shutter board while becoming interruption state by mismatching of the hole, and the second selection terminal hole becomes interruption state by being covered by one of the side edges of the shutter board while becoming the open state by protruding out of the side edge.

The plurality of selection terminal holes may preferably be provided with a third selection terminal hole formed in the angular direction different from the first and the second selection terminal holes with respect to the common terminal hole and the third selection terminal hole preferably is made to be in the interruption state by covering it with the other side edge of the shutter board and is made to be in the open state by protruding out of the other side edge.

With such a structure, the selection terminal hole can be provided at a location with arbitrary radial distance from the center of the rotation of shutter board as long as it is a location where side edges of the shutter board appear and disappear. Therefore, degree of design freedom for the positioning of selection terminal hole is high, which improves the usability and the design characteristics.

Embodiments of the invention will now be described by way of example only with reference to the accompanying diagrammatic figures, in which;
Figure 1 is a schematic structural drawing showing an external view of the multimeter and structure of the erroneous input prevention mechanism embedded in the multimeter of a first embodiment of the present invention.
Figure 2 is a schematic top view showing a structure of an erroneous input prevention mechanism in the multimeter in Figure 1.
Figure 3 is a cross section along a line X-X' in Figure 2.
Figure 4 is a cross section along a line Y-Y' in Figure 2.
Figure 5 is an exploded view of the slave wheel used in the erroneous input prevention mechanism in the multimeter of Figure 1.
Figure 6 is a drawing illustrating a counter-clockwise rotation of the rotary switch from the position of Figure 2 in the multimeter of Figure 1.
Figure 7 is a drawing illustrating a counter-clockwise rotation of the rotary switch from the position of Figure 5 in the multimeter of Figure 1.
Figure 8 is a drawing illustrating a clockwise rotation of the rotary switch from the position of Figure 2 in the multimeter of Figure 1.
Figure 9 is a drawing illustrating a clockwise rotation of the rotary switch from the position of Figure 8 in the multimeter of Figure 1.
Figure 10 is a schematic structural drawing showing the structure of the shutter board driving mechanism formed in the multimeter of a second embodiment of the present invention.
Figure 11 is a schematic structural drawing showing the structure of the shutter board driving mechanism formed in the multimeter of a third embodiment of the present invention.
Figure 12 is a schematic structural drawing showing the structure of the shutter board driving mechanism formed in the multimeter of a fourth embodiment of the present invention.
Figure 13 is a drawing illustrating the condition of rotating the rotary switch one step clockwise from the position in Figure 12 in the shutter board driving mechanism of the multimeter of Figure 12.
Figure 14 is a drawing illustrating the condition of rotating the rotary switch one step clockwise from the position in Figure 13 in the shutter board driving mechanism of the multimeter of Figure 12.
Figure 15 is a drawing illustrating the condition of rotating the rotary switch one step counter-clockwise from the position in Figure 12 in the shutter board driving mechanism of the multimeter of Figure 12.
Figure 16 is a drawing illustrating the condition of rotating the rotary switch one step counter-clockwise from the position in Figure 15 in the shutter board driving mechanism of the multimeter of Figure 12.
Figure 17 is a schematic structural drawing showing the structure of the shutter board driving mechanism formed in the multimeter of a fifth embodiment of the present invention.
Figure 18 is a schematic structural drawing showing the structure of the shutter board driving mechanism formed in the multimeter of a sixth embodiment of the present invention.
Figure 19 is a schematic structural drawing showing the structure of the shutter board driving mechanism formed in the multimeter of a seventh embodiment of the present invention.
Figure 20 is a drawing illustrating an erroneous input prevention mechanism in a conventional multimeter.

The embodiments of the present invention will be described hereafter, with reference to the drawings.

### Embodiment 1

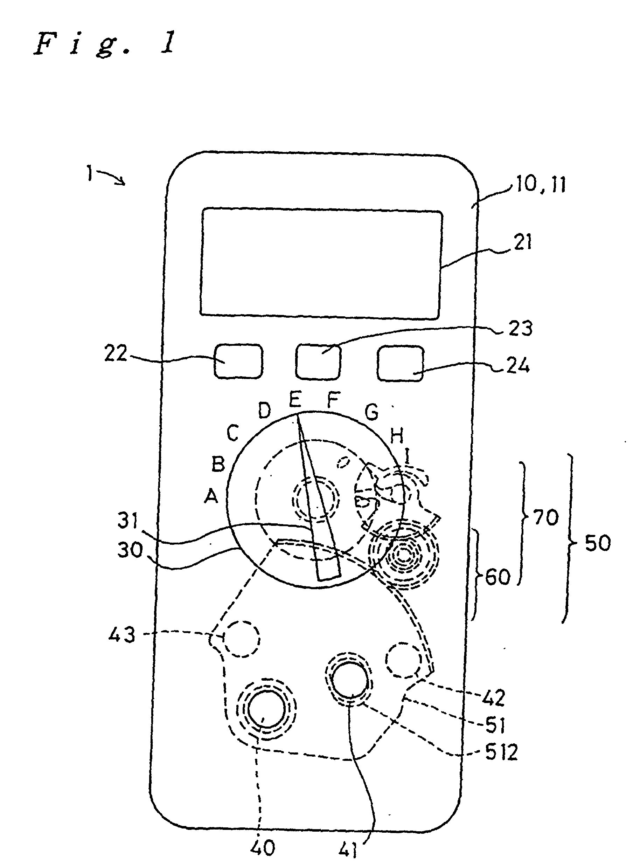

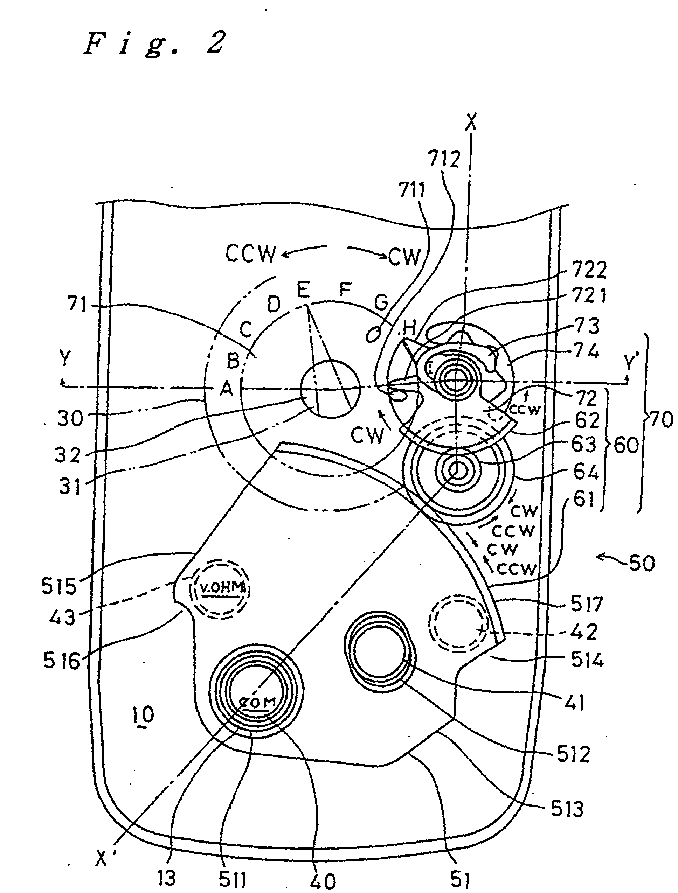

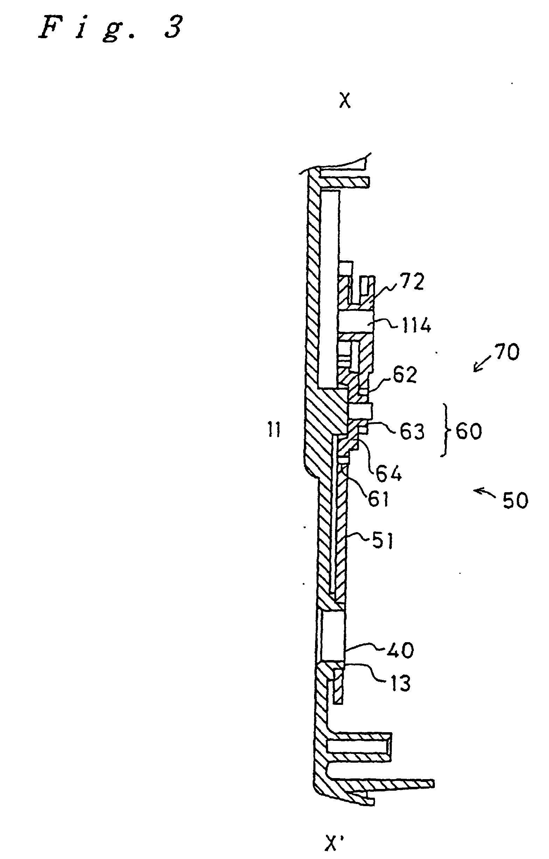

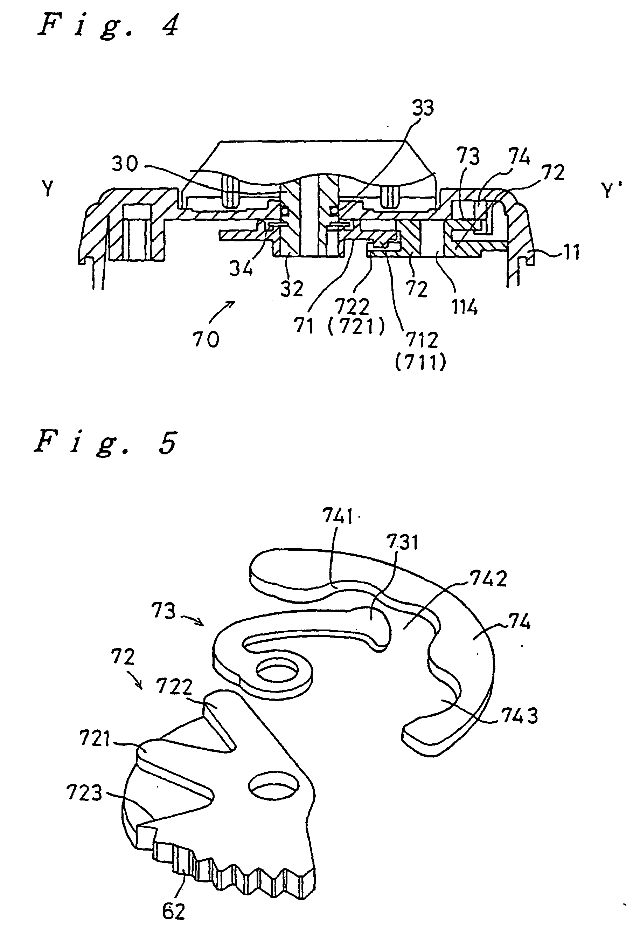

Figure 1 is a schematic diagram showing a major part of the internal structure and the external appearance of the multimeter in the embodiment. Figure 2 is a schematic top view showing the structure of the embedded erroneous input prevention mechanism. Figure 3 is a cross section with respect to line X-X' in Figure 2 and Figure 4 is a cross section with respect to line Y-Y' in Figure 2.

### Overall Structure

In Figure 1, the multimeter with an erroneous input prevention mechanism of the present embodiment is a digital multimeter and a circuit board and a battery (not represented) are stored inside a square shape resin case 10. The case 10 comprises a top case 11 and a bottom case, with a rectangular display unit 21 made of a liquid crystal display panel being formed in a location towards the end of the top case 11. Three switches 22, 23, 24 are formed below the display unit 21 with each switch being provided with such functions as turning off the power source and holding measurement values.

A rotary switch 30 with a knob 31 similar to an ordinary multimeter is placed in the central section of the case 10. Indices A - I showing each measuring mode and range for multimeter 1 to execute are recorded at equal intervals along the perimeter of the rotary switch 30, which is selected by the pointing of the tip of the knob 31 with the rotation of the rotary switch 30. For example, in the condition shown in Figure 1, the tip of the knob 31 points to the index E indicating electric current measuring mode whose range is µA. Here, a stopper (unrepresented) is formed for the rotary switch 30 to prevent the rotation beyond the predetermined range.

A negative common terminal hole 40 (common terminal hole) into which one of the two test lead pin plugs (unrepresented) is plugged when various measurements are performed is provided on the top surface of the case 10. Moreover, a first input terminal hole 41 is formed at a location separated by a predetermined distance from the negative common terminal hole 40 on the top surface of case 10 as a positive input terminal hole (selection terminal hole) into which the other test lead pin plug is plugged. This first input terminal hole 41 is for electric current measurement with a range µA - mA. Moreover, a second input terminal hole 42 is provided on the top surface of the case 10 at a location with an angular direction substantially the same as the first input terminal hole 41 and a different distance with respect to the negative common terminal hole 40. This second input terminal hole 42 is also for electric current measurement like the first input terminal hole 41 but for the 10A range. The third input terminal hole 43 is provided on the top surface of the case 10 at a location with an angular direction different from the first input terminal hole 41 and the second input terminal hole 42. This third input terminal hole 43 is for voltage measurement and resistance measurements. Corresponding to these input terminal holes, an appropriate resistance is placed and various measurement circuits are composed in the internal circuit.

With the multimeter 1 thus composed, when the tip of the knob 31 of the rotary switch 30 is pointed to the index E, electric current measurement mode is enabled with a range of µA. Hence, if a large electric current is input accidentally to the multimeter 1 under this condition, internal circuits of the multimeter 1 can be destroyed, which is dangerous to the user. Hence an erroneous input prevention mechanism 50 is provided in the present embodiment, which will be described below.

With the erroneous input prevention mechanism 50, first, a shutter board 51 is placed on the back side of the top case 11 as shown in Figure 2 and Figure 3. A round hole 511 and an elongated hole 512 are formed on the shutter board 51. The elongated hole 512 is used to plug in a pin plug of the test lead by causing the second input terminal hole 41 to be in the open state as shown in Figure 2. On the other hand, a cylindrical section 13 of the top case 11 is fitted in the round hole 511 which rotates around the negative common terminal hole 40. In this condition, the shutter board 51 is held by the top case 11 and is able to rotate along the back side of the top case 11 with the center of rotation at cylinder section 13 (negative common terminal hole 40).

A notch 514 is formed in one side edge 513 of the shutter board 51, towards the tip and this notch 514 opens the second input terminal hole 42 to enable plugging in of the pin plug of the test lead there, which will be shown later. Moreover, another notch 516 is formed in the other side edge 515 of the shutter board 51, towards the center of rotation and this notch 516 opens the third input terminal hole 43 to enable plugging in of the pin plug of the test lead there, which will be described later. Moreover, an outer gear 61 is formed on the tip part of the shutter board 51.

A shutter board driving mechanism 70 to mechanically connect the rotary switch 30 and the shutter board 51 is formed in the erroneous input prevention mechanism 50. In other words, in the shutter board driving mechanism 70, the rotation center axle 32 to support rotary switch 30 is attached to the top case 11 through a bearing 33 as shown in Figure 2 and Figure 4, and is made to rotate with the rotary switch 30 as one unit. A disc-shape selector 71, which is freely interchangeable, is attached to the bottom end of the rotation central axle 32 through a stop ring 34 and the selector 71 is made to rotate with the rotary switch 30 as one unit. Here, a connector unit (unrepresented) and the like to connect with inner circuit is formed in the vicinity of the bottom end part of the rotation center axle 32. Here, the rotary switch 30 is made to click at every angular position of 20°, hence, the selector 71 is also made to click every angular position of 20°. The first and the second drive-side protrusions 711, 712 are formed in the bottom surface of the selector 71 at locations separated by 60° from each other around the rotational central axle 32 as shown in Figure 2, with only the second drive-side protrusion 712 appearing in Figure 4.

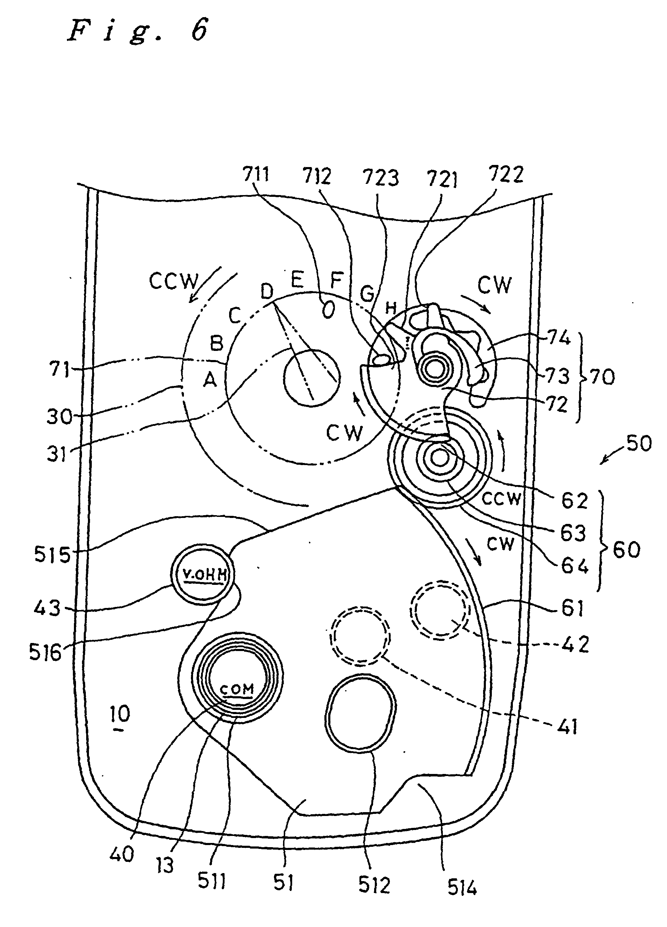

At the side edge section of the selector 71, a slave wheel 72 (slave member) is fitted free to rotate, on the rotation center axle 114 protruding downward from the top case 11. The slave wheel 72 overlaps partially on the selector 71 and is positioned at the bottom surface side of the sector 71. The first and the second slave-side protrusions 721, 722 are formed protruding towards the outer perimeter at locations separated by 45° from each other as magnified in Figure 5. Moreover, an outer gear 62 is formed along the outer perimeter section of a fan-shaped main body 723 of the slave wheel 72.

A base edge unit of a spring 73 is attached to the central section of the slave wheel 72 as one unit with the tip unit 731 of the spring 73 protruding slightly towards the outer perimeter. A receiving board 74 anchored on the top case 11 is positioned outside of the spring 73 and first, second and third indentations 741, 742, 743 are formed inside the receiving board 74 with an angular interval of 45°. Here, the tip unit 731 of the spring 73 is energized towards the receiving board 74, hence, with a rotation of the slave wheel 72 the tip unit 731 enters inside the second indentation 742 after climbing over from the inside of the first indentation 741 onto a broader section of the second indentation 742, for example. Hence, when the selector 71 rotates with the rotary switch 30, the first or the second drive-side protrusion 711, 712 pushes aside the first or the second slave-side protrusion 721, 722 while the slave wheel 72, rotating with the selector 71, is made to click at every 45° corresponding to the location where the first through the third indentations 741, 742, 743 are formed in the receiving board 74.

Referring back to Figure 2 and Figure 3, a gear mechanism 60 (transmission mechanism) to connect the slave wheel 72 and the shutter board 51 is formed in the shutter board driving mechanism 70 of the erroneous input prevention mechanism 50. In other words, a small gear 63 is engaged in the outer gear 62 of the slave wheel 72 in the gear mechanism 60 and a large gear 64 is engaged in the outer gear 61 of the shutter board 51. In addition, the small gear 63 and the large gear 64 are made to form one unit, hence with a rotation of the slave wheel 72, both the small gear 63 and the large gear 64 rotate through the outer gear 62 and such rotational motion is made to be transmitted to the shutter board 51 through the outer gear 61.

### Operation

Hereafter, the operation of multimeter structured in the manner mentioned above will be described.

First, in the condition described in Figure 2, the tip of the knob 31 of the rotary switch 30 is pointed towards the index E, indicating the electric current measurement mode with the range of µA. In this state, the elongated hole 512 of the shutter board 51 and the first input terminal hole 41 for use in µA - mA range overlap each other, enabling measurement of the small electric current by plugging in the pin plug of the test lead to the first input terminal hole 41.

Next, the operation of the erroneous input prevention mechanism 50 at the time of switching to direct current voltage measurement mode by rotating the rotary switch 30 20° counter-clockwise (in the direction of arrow CCW) from the above position to point the tip of the knob 31 towards index D will be described with reference to Figure 2 and Figure 6.

Firstly, when the rotary switch 30 is rotated 20° counter-clockwise (direction of the arrow CCW) from the position in Figure 2, the selector 71 also rotates 20° counter-clockwise (direction of arrow CCW). Hence, the second drive-side protrusion 712 pushes the first slave-side protrusion in clockwise direction (in the direction of the arrow CW) and the slave wheel 72 is made to click by spring 73 and the receiving board 74 as shown in Figure 6 and rotates 45° clockwise (in the direction of the arrow CW). Next, due to the rotation of the slave wheel 72, the small gear 63 and the large gear 64 rotate 134.76° counter-clockwise (in the direction of the arrow CCW), causing the shutter board 51 to rotate 35° clockwise (in the direction of the arrow CW). As a result, the elongated hole 512 of the shutter board 51 moves away from the location on which the first input terminal hole 41 for µA - mA range use is formed, causing the first input terminal hole 41 to be in the interrupted state by the shutter board 51. Here, the second input terminal hole 42 for 10A range use continues to be in interrupted state. On the other hand, the third input terminal hole 43 for measuring voltage and resistance protrudes from the other side edge section 515 of the shutter board 51 and becomes open state at notch 516. Hence the measurement of direct current voltage is enabled by plugging in the pin plug of the test lead into the third input terminal hole 43.

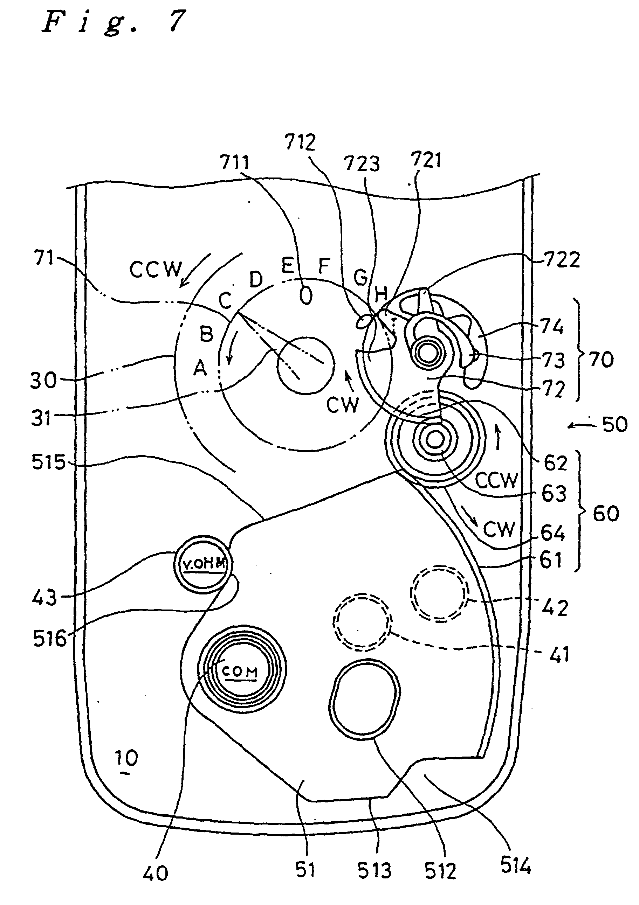

Next, an operation of the erroneous input prevention mechanism 50 at the time of switching to alternating current voltage measurement mode by rotating the rotary switch 30 20° counter-clockwise (in the direction of the arrow CCW) again from this position to point the tip of the knob 31 towards index C, will be described in reference to the Figure 7.

First when the rotary switch 30 is rotated 20° counter-clockwise (in the direction of the arrow CCW) again from the present position described in Figure 6, the selector 71 also rotates 20° counter-clockwise (in the direction of the arrow CCW). However, the second drive-side protrusion 712 and the first drive-side protrusion 711, do not push aside either the first or the second slave-side protrusions 721, 722 and the slave wheel 72 does not rotate. Hence, the shutter board 51 does not rotate. In other words, the third input terminal hole 43 for voltage and resistance measurement remains in the open state by the notch 516 at the other side edge section 515 of the shutter board 51 and the pin plug of the test lead is left plugged in the third input terminal hole 43, enabling the measurement of the alternate current voltage.

Hereafter, switching of the tip of the knob 31 successively from index C (alternating current voltage frequency measurement mode), to index B (resistance measurement mode) and to index A (temperature measurement mode using a temperature sensor), by rotating rotary switch 30 counter-clockwise (in the direction of arrow CCW) further by 20° increments, leaves the third input terminal hole 43 for voltage and resistance measurement use in the open state by the notch 516 at the other side edge section 515 of the shutter board 51 because the slave wheel does not rotate. Thus, in the present embodiment various measurements including direct current voltage, alternate current voltage, frequency, resistance and temperature, can be performed simply by providing the negative common terminal hole 40 and the third input terminal hole 43.

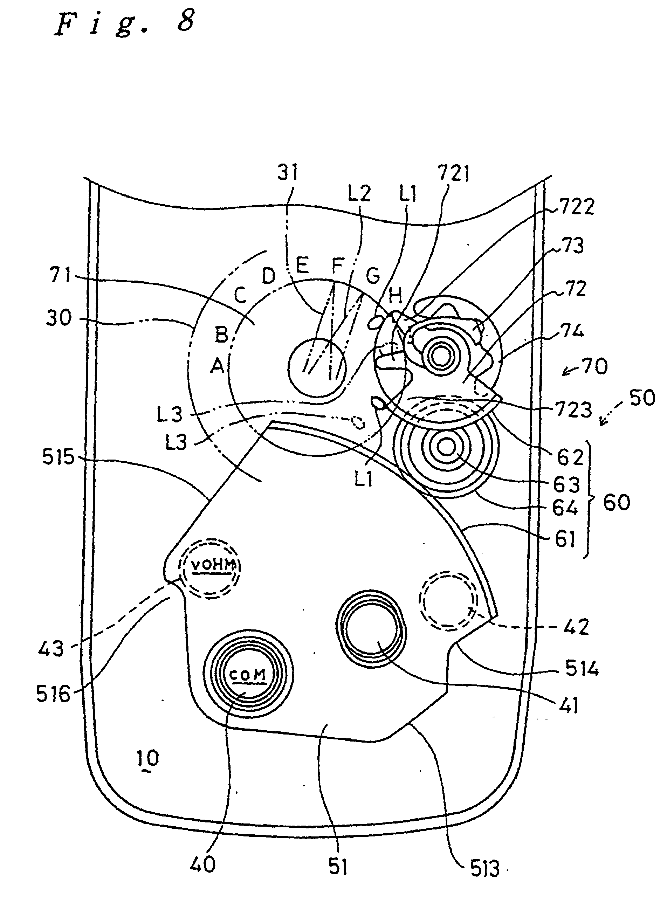

The operation of the erroneous input prevention mechanism 50 at the time of switching to electric current measurement mode with 1 mA range by rotating the rotary switch 30 to 20° clockwise (in the direction of arrow CW) from above position to point the tip of the knob 31 towards index F will be described with reference to Figure 2 and Figure 8.

First, when the rotary switch 30 is made to rotate 20° clockwise (in the direction of the arrow CW) from the position in Figure 2, the selector 71 also rotates 20° clockwise (in the direction of arrow CW). However, with the rotation of 20° clockwise, the first drive-side protrusion 711 does not move to the position to push away the first slave-side protrusion 721, as shown by the solid line L1 (the position of the drive-side protrusions 711 and 712 ) in Figure 8. Hence, the slave wheel 72 does not rotate, nor does the shutter board 51. In other words, the elongated hole 512 of the shutter board 51 leaves the first input terminal hole 41 for µA - mA range use in the open state.

Moreover, even when the knob 31 is further rotated 20° clockwise from the position in Figure 8 to the position shown by the dotted line L2 to point the tip of the knob 31 towards the index G to switch to electric current measurement mode with 100 mA range, the first drive-side protrusion 711 does not move to the position to push away the first slave side protrusion 721 as shown by the dotted line L3 (the position of protrusion of the drive-side protrusions 711 and 712) in Figure 8. Hence, the slave wheel 72 does not rotate, nor does the shutter board 51. In other words, the elongated hole 512 of the shutter board 51 leaves the first input terminal hole 41 for µA -mA range use in the open state.

Hence, with the present embodiment, wide range of measurement is performed for a small electric current simply by using the negative common terminal hole 40 and the first input terminal hole 41.

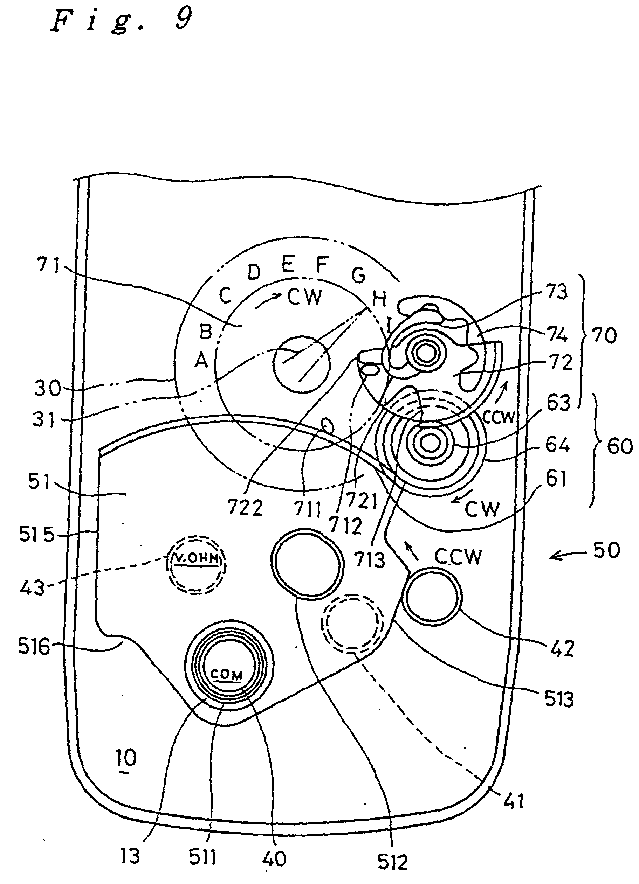

The operation of the erroneous input prevention mechanism 50 at the time of switching to the electric current measurement mode with the 10A range by rotating the rotary switch 30 20° clockwise again (in the direction of arrow CW) from the position in Figure 8 to point the tip of the knob 31 towards index H will be described with reference to Figure 8 and Figure 9.

First when the rotary switch 30 is rotated 20° clockwise (direction of the arrow CW) from the position in Figure 8, the selector 71 also rotates 20° clockwise (direction of arrow CW). Hence, the first drive-side protrusion 711 rotates 20° clockwise (direction of arrow CW) from the position indicated by the dotted line L3 and pushes away the first slave-side protrusion 721 in counter-clockwise direction (in the direction of the arrow CCW) and the slave wheel 72 is made to click by the spring 73 and the receiving board 74 as shown in Figure 9 and rotates 45° counter-clockwise (in the direction of the arrow CCW). Next, due to the rotation of the slave wheel 72, the small gear 63 and the large gear 64 rotates 134.76° clockwise (in the direction of the arrow CW), causing the shutter board 51 to rotate 35° counter-clockwise (in the direction of the arrow CCW). As a result, the elongated hole 512 of the shutter board 51 moves away from the location on which the first input terminal hole 41 for µA - mA range use is formed, causing the first input terminal hole 41 to be in interrupted state by shutter board 51. Moreover, the third input terminal hole 43 for measuring voltage and resistance continues to be in the interrupted state by shutter board 51. On the other hand, the second input terminal hole 42 for electric current measurement with 10A range use changes to open state by the notch 514 at the other side edge section 513 of the shutter board 51. Hence the measurement of large electric current is enabled by plugging in the pin plug of the test lead into the second input terminal hole 42.

Moreover, even when the knob 31 is further rotated 20° clockwise (direction of arrow CW) from the position in Figure 9 to point the tip of the knob 31 towards the index I, the shutter board 51 does not rotate, hence the second input terminal hole 42 for measurement of electric current with 10A range is left in the open state at the other side edge of the shutter board 51.

Here, the operation of the erroneous input prevention mechanism 50 to switch back to the electric current measurement mode for the 100 mA range by returning the tip of the knob 31 to index G by rotating the rotary switch 30 20° counter-clockwise (direction of the arrow CCW) from the position in Figure 9 is opposite to the operation described above.

In other words, when the rotary switch 30 is rotated 20° counter-clockwise (direction of the arrow CCW) from the position in Figure 9, the selector 71 also rotates 20° counter-clockwise (direction of arrow CCW). Hence, the first drive-side protrusion 711 pushes away the second slave-side protrusion 722 in the clockwise direction (in the direction of the arrow CW) and the slave wheel 72 is made to click by spring 73 and the receiving board 74 and rotates 45° clockwise (in the direction of the arrow CW). Next, due to the rotation of the slave wheel 72, the small gear 63 and the large gear 64 rotates 134.76° counter-clockwise (in the direction of the arrow CCW), causing the shutter board 51 to rotate 35° clockwise (in the direction of the arrow CW). As a result, the second input terminal hole 42 for measurement of electric current for 10A range is interrupted by one side edge section 513 of the shutter board 51. On the other hand, the first input terminal hole 41 for µA - mA range use returns to open state by the elongated hole 512 of the shutter board 51.

### Major Efficacy of Embodiment 1

As described above, in the multimeter of the present embodiment, when the measurement mode and the range is selected by the switching of rotary switch 30, only the input terminal hole satisfying the corresponding condition becomes open state, hence an accidental incorrect plugging in of test lead pin plug is avoided. Thus, erroneous input to multimeter is avoided, resulting in a multimeter having fewer failure and being safe to use.

Moreover, in the multimeter of the present embodiment, the shutter board driving mechanism 70 is structured in such a manner that the first and the second slave-side protrusions 721 and 722 formed in the slave wheel 72 are pushed away by the first and the second drive-side protrusions 711, 712. Hence, depending on the location of formation of these protrusions, even when the rotary switch 30 is rotated, the shutter board does not rotate, causing the same input terminal hole to be in the open state, as described above. Hence, it becomes possible to assign more than one function to one input terminal hole while maintaining the erroneous input prevention mechanism operative. Moreover, the first and the second drive-side protrusions 711, 712 are provided at locations separated from each other by a predetermined angle range, hence the shutter board driving mechanism 70 provides, within the range of the angle of rotation of the rotary switch 30, in between connection positions to interlock the rotation of shutter board 51 and rotary switch 30 by mechanically connecting shutter board 51 and the rotary switch 30 (the position to point the knob 31 from index D to index E and the position to point the knob 31 from index G to index H), interrupting positions to stop the shutter board 51 in spite of rotation of rotary switch 30 by interrupting the mechanical connection of the shutter board 51 and the rotary switch 30 (the position to point the knob 31 from index E to index F and the position to point the knob 31 from index F to index G.) Hence, the present embodiment increases the degree of design freedom since more than one mode can be assigned to the first input terminal hole 41 positioned substantially in the central section in addition to the second and the third input terminal hole 42, 43 positioned substantially in both ends out of all the input terminal holes selected by the rotary switch 30.

Moreover, because the selector 71 is easily interchangeable on the rotary switch 30, the operation of the rotary switch 30 and the opening-closing pattern of the input terminal hole can be changed easily by simply replacing selector 71 with the one having the first and the second drive-side protrusions 711, 712 formed at different locations. For example, the present embodiment is structured in such a manner that the third input terminal hole 43 becomes the open state when the tip of the knob 31 points to indices A, B, C and D, the first input terminal hole 41 becomes the open state when the tip of the knob 31 points to indices E, F and G, and the second input terminal hole 42 becomes the open state when the tip of the knob 31 points to indices H and I but it can easily be altered to a structure wherein the third input terminal hole 43 becomes the open state when the tip of the knob 31 points to indices A, B, and C, the first input terminal hole 41 becomes the open state when the tip of the knob 31 points to indices D, E, F, G and H, and the second input terminal hole 42 becomes the open state when the tip of the knob 31 points to index I by simply shifting the position of the first drive-side protrusion 711 20° clockwise with respect to the knob 31 and shifting the position of the second drive-side protrusion 712 20° counter-clockwise with respect to the knob 31.

Moreover, with the multimeter of the present embodiment, the shutter board 51 is made to rotate with the center of rotation at the negative common terminal hole 40 which is always in the open state. Hence, the negative common terminal hole 40 need not be formed at the location shifted from the range of the rotation of the shutter board 51. Thus, the restriction on the size and the range of the rotation of the negative common terminal hole 40 is eased, increasing the degree of design freedom accordingly. Moreover, the negative common terminal hole 40 need not be formed separately at the location shifted from the shutter board 51, enabling miniaturization of the multimeter accordingly.

Furthermore, in a conventional multimeter, the input terminal hole is opened and closed only at the holes formed on the shutter board, which restricts the location of the formation of input terminal hole to locus of the hole when the shutter board is moved but the present embodiment is not restricted to such a locus. In other words, in the present embodiment, when the second and the third input terminal hole 42, 43 are selectively made to become the open state out of all of the input terminal holes, the input terminal holes are made to protrude from the side edge sections 513, 515, hence, the second and the third input terminal hole 42, 43 can be formed at locations within an arbitrary radius from the negative common terminal hole 40 which is the center of rotation of the shutter board 51 as long as the location corresponds to the side edge sections 513, 515. Hence, it is possible to improve usability and enhance design characteristics by placing the first input terminal hole 41 and the second input terminal hole 42 for use in electric current measurement close together as in the present embodiment.

### Embodiment 2

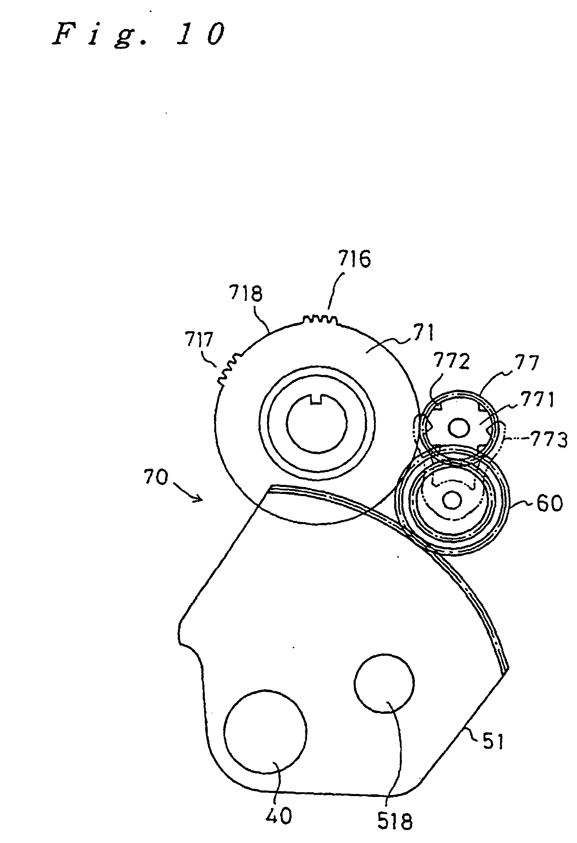

In embodiment 1, the drive-side protrusion protruding downwards from the selector 71 and the slave-side protrusion protruding sideways from the slave wheel 72 are used to transmit the rotation of the rotary switch 30 to the shutter board 51 but instead of such selector 71, a gear having an outer gear (drive-side protrusion) within predetermined angle range can be used so that the outer gear of the gear, functioning as a slave member, can receive the rotational motion as described in Figure 10.

Figure 10 is a schematic top view typically describing the structure of the shutter board driving mechanism in the present embodiment. The multimeter of each of the embodiment to be described hereafter has basic structure same as the embodiment 1, hence the parts with the same function will be identified with the same symbol and the detailed explanation and illustration thereof will be omitted.

In Figure 10, a first outer gear formation region 716 (the first drive-side protrusion) is formed in the outer perimeter of the selector 71 which is interchangeable on the rotary switch (unrepresented), and a second outer gear formation region (the second drive-side protrusion) 717 is formed being separated by a predetermined angle range from the first outer gear formation region 716. A slave gear 77 (slave member) is placed in the side section of the selector 71 and its outer gear (slave-side protrusion) is made to engage with the outer gear formed in the first and the second outer gear formation regions 716, 717 of the selector 71. Here, a plurality of notches 772 are formed with a predetermined angle interval in the disc 771 which is formed as one unit with the slave gear 77 and the tip section of the spring 773 fits in these notches, causing the slave gear 77 to click. With the shutter board driving mechanism structured above, the slave gear 77 and the shutter board 51 are connected mechanically by the gear mechanism 60, hence, with the rotation of the slave gear 77, the shutter board 51 rotates with the center of rotation at the common terminal hole 40 and selects input terminal hole (unrepresented) to become a pair with common terminal hole based on the position of the hole 518. Thus, when the measurement mode and the range is selected by the switching of rotary switch 30, only the input terminal hole satisfying the corresponding condition becomes the open state, hence an accidental plugging in of the test lead pin plug is avoided. Thus, erroneous input to the multimeter is avoided, resulting in a multimeter having few failures and which is safe to use.

Here, the first outer gear formation region 716 and the second outer gear formation region 717 formed in the selector 71 are separated from each other by a predetermined angle range, hence when the outer gears of the first and the second outer gear formation regions 716, 717 are engaged with the outer gear of the slave gear 77, the rotary switch and the shutter board 51 are connected mechanically. Therefore the shutter board 51 rotates interlocked with the rotation of the rotary switch.

On the other hand, if the part facing the slave gear 77 is the part 718 (the part where no outer gear is formed) located between the first outer gear formation region 716 and the second outer gear formation region 717, the slave gear 77 does not rotate even if rotary switch is rotated. Hence, the shutter board 51 remains in the position of selecting the same input terminal hole even if the measurement mode and range are changed by a switching of the rotary switch. This enables assignment of more than one function to one input terminal hole. Moreover, because the first and the second outer gear formation regions 716, 717 are formed in locations which are separated from each other by a predetermined angle range, the shutter board driving mechanism 70 has positions to interrupt mechanical connection of the shutter board 51 and the rotary switch in between the positions where the shutter board 51 and the rotary switch are connected mechanically within the range of angle of rotation of the rotary switch. Hence, the present embodiment increases the degree of design freedom since more than one mode can be assigned to the input terminal hole positioned substantially in the central section in addition to the input terminal hole positioned substantially in both ends out of all the input terminal hole selected by the rotary switch 30.

### Embodiment 3

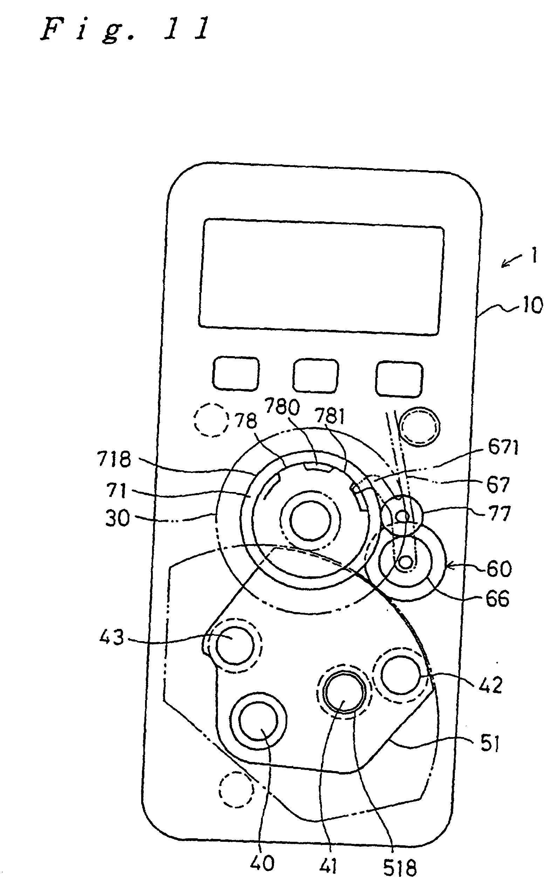

Figure 11 is a schematic top view typically describing the structure of the shutter board driving mechanism in the present embodiment.

In Figure 11, an outer gear 77 is formed on the entire outer perimeter of the selector 71 which is interchangeable on the rotary switch 30. Moreover, a slave gear 77 is placed on side section of the selector 71 with its outer gear engaging in the outer gear 718 of the selector 71. Since the slave gear 77 and the shutter board 51 are mechanically connected through the gear mechanism 60, the shutter board 51 rotates with the center at common terminal hole 40 with the rotation of the slave gear 77 and selects an input terminal hole to form a pair with the common terminal hole from the first, the second and the third input terminal hole 41, 42, 43 based on the location of the hole 518. Hence, when the measurement mode and the range is selected by the switching of rotary switch 30, only the input terminal hole satisfying the corresponding condition becomes the open state and an accidental plugging in of test lead pin plug is avoided.

Here, the rotation center axis of the slave gear 77 is supported by the spring 67 which is suspended between inside of the case 10 and the rotation center axis of the gear 66 of the gear mechanism 60. At the same time, a disc 78 is provided in the selector 71 to form one unit with protrusions 781 being formed along the outer perimeter of the disc 78 with a predetermined angle interval. Hence, when the protrusion 671 protruding from the spring 67 is positioned at location 780 (inside indentation) between protrusions 781 of the disc 78, the slave gear 77 is at the location close to the selector 71 where the outer gear 718 of the selector 71 and the outer gear of the slave gear 77 mesh each other, as described in Figure 11. Hence, if the rotary switch 30 is rotated in this condition, the shutter board 51 also rotates.

On the other hand, if the protrusion 671 of the spring 67 hits the protrusion 781 of the disc 78, the slave gear 77 is away from the selector 71, thus the outer gear 718 of the selector 71 and the outer gear of the slave gear release the engagement. Hence, the slave gear 77 does not rotate even if the rotary switch 30 is rotated and the shutter board 51 does not rotate while the same input terminal hole continues to be in the selected state. Thus, one input terminal hole can have more than one function. Moreover, the protrusion 781 is formed at the location separated by a predetermined angle range, hence positions are provided to interrupt the mechanical connection of the shutter board 51 and rotary switch in between the positions where the shutter board 51 and the rotary switch are mechanically connected within the range of angle of rotation of the rotary switch. Hence, the present embodiment increases the degree of design freedom since more than one mode can be assigned to the first input terminal hole 41 positioned substantially in the central section in addition to the second and the third input terminal hole positioned substantially in both ends out of all the input terminal hole selected by the rotary switch 30.

### Embodiment 4

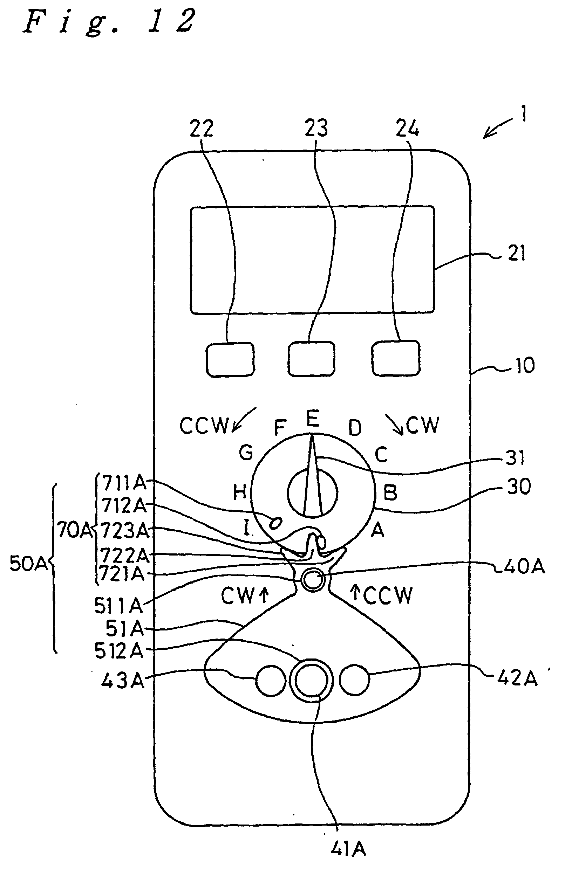

Figure 12 is a schematic drawing describing an external view of a multimeter and the structure of erroneous input prevention mechanism to be mounted on the multimeter in the present embodiment. The present embodiment differs from the embodiment 1 through embodiment 3 in that the present embodiment does not have a slave wheel and the like between the rotary switch and shutter board.

### Overall Structure

In Figure 12, the multimeter with an erroneous input prevention mechanism of the present embodiment is also a digital multimeter and a rotary switch 30 with a knob 31 is provided like an ordinary multimeter in a square resin case 10. A rectangular display unit 21 made of a liquid crystal display panel is formed in a location towards the top of the top case 11. Three switches 22, 23, 24 are formed below the display unit 21 with each switch being provided with such functions as turning off power source and holding measurement values. Indices A to I showing each measuring mode and range for multimeter 1 to execute are recorded with equal interval along the perimeter of the rotary switch 30, modes are selected by the pointing of the tip of the knob 31 with the rotation of the rotary switch 30.

A negative common terminal hole 40A (common terminal hole) into which one of the two test lead pin plugs (unrepresented) is plugged is provided on the top surface of the case 10. Moreover, a first through a third input terminal hole 41A, 42A, 43A are formed at the locations, each of which are separated by the predetermined distance from the negative common terminal hole 40A on the top surface of case 10 as a positive input terminal hole (selection terminal hole) into which the other test lead pin plug is plugged. Out of these three input terminal holes, the first input terminal hole 41A in the center is for electric current measurement with a range µA - mA. Moreover, the second input terminal hole 42A is also for electric current measurement like the first input terminal hole 41A but is for 10A range. The third input terminal hole 43A is for voltage measurement and resistance measurement.

With a multimeter 1 thus composed, when the tip of the knob 31 of the rotary switch 30 is pointed to the index E, electric current measurement mode is enabled with a range of µA. Hence, if a large electric current is input accidentally to the multimeter under this condition, internal circuits of the multimeter 1 are destroyed, which is dangerous to the user. Hence an erroneous input prevention mechanism 50A is provided in the present embodiment, which will be described below.

In the erroneous input prevention mechanism 50A, first a shutter board 51A is placed along the back side of the case 10. A relatively large round hole 512A is formed on the shutter board 51A. The round hole 512A is for plugging in the pin plug of the test lead by making the first input terminal hole 41A in the open state. Another round hole 511A is formed on the shutter board 51A to keep the negative common terminal hole 40A always in the open state which becomes the center of rotation of the shutter board 51A.

Moreover, a shutter board driving mechanism 70A to connect the rotary switch 30 and the shutter board 51 A mechanically is formed on the erroneous input prevention mechanism 50A. For the shutter board driving mechanism 70A, first and second drive-side protrusions 711A and 712A, separated by a predetermined angle range, are formed from the back side of the rotary switch 30 towards inside of the case 10. At the same time, three slave-side protrusions (first through third slave-side protrusions 721A, 722A, 723A) protrude from the shutter board 51A towards rotary switch 30. Hence, the first and the second drive-side protrusions 711A, 712A push away the first through the third slave-side protrusions 721A, 722A, 723A with rotation of the rotary switch 30, the shutter board 51 A is able to rotate as much as predetermined angle range between the first and second drive-side protrusions 711A and 712A with the center of rotation at the location on which common terminal hole 40A is formed. Here, the shutter board 51A is made to click at each predetermined angle range by a click mechanism (unrepresented) embedded in the case 10.

### Operation

First in the condition described in Figure 12, the tip of the knob 31 of the rotary switch 30 is pointed towards the index E, indicating the electric current measurement mode with the µA range. In this state, the round hole 512A of the shutter board 51A and the first input terminal hole 41A for use in µA - mA range overlap each other, enabling measurement of the small electric current by plugging in the pin plug of the test lead to the first input terminal hole 41A.

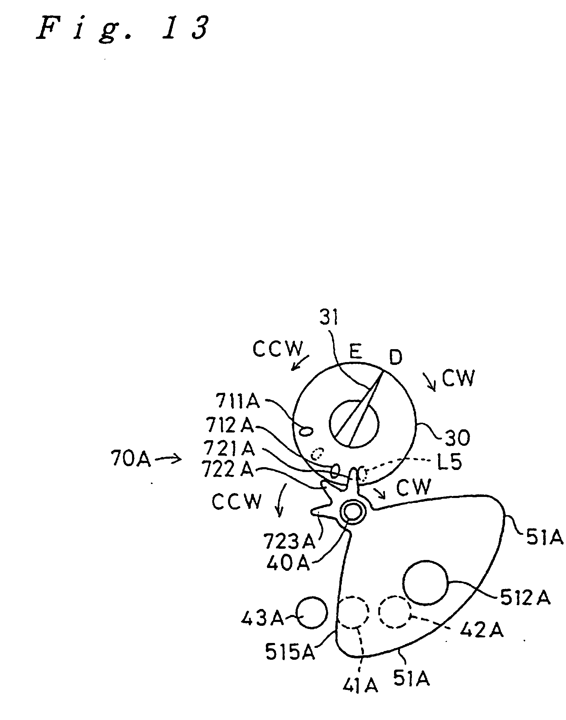

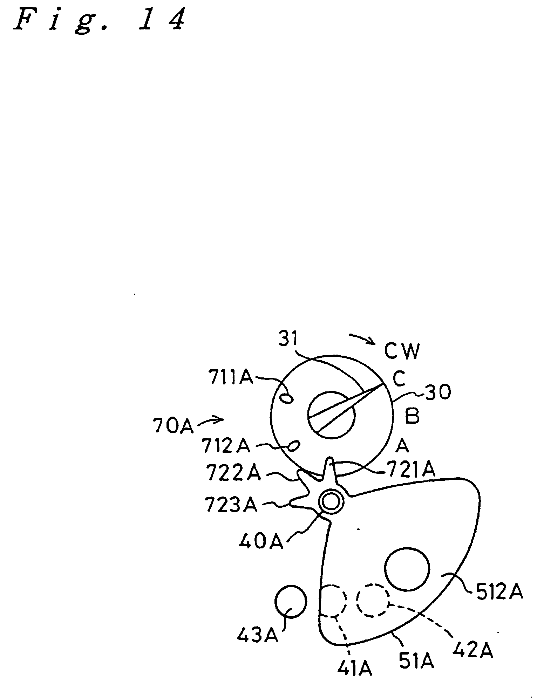

When the tip of the knob 31 is made to point to index D from this position with the rotation of rotary switch 30 by an amount equivalent to one step clockwise (direction of arrow CW), the second drive-side protrusion 712A pushes away the second slave-side protrusion 722A counter-clockwise (direction of arrow CCW), as shown in Figure 13, hence, the shutter board 51A makes a click and rotates counter-clockwise (direction of arrow CCW) by the amount equivalent to one step. As a result, the round hole 512A in the shutter board 51A moves away from the position where the first input terminal hole 41A for µA -mA range use is formed, causing the first input terminal hole 41 A to be in the interruption state. Moreover, the second input terminal hole for 10A range use remains in the interruption state by the shutter board 51A. On the other hand, the third input terminal hole 43A for measurement of voltage and resistance protrudes from the side edge section 515A of the shutter board 51A and changes to be in the open state. Hence, measurement of the direct current voltage becomes possible by plugging in the pin plug of the test lead into the third input terminal hole 43A. When the tip of the knob 31 is made to point to index C from this position with the further rotation of the rotary switch 30 by an amount equivalent to one step clockwise (direction of arrow CW), the shutter board 51 A does not rotate as shown in Figure 14. Hence, the third input terminal hole for measurement of voltage and resistance remains in the open state at the side edge section of the shutter board 51A, enabling the measurement of alternating current voltage with the pin plug of the test lead continuing to be plugged in the third input terminal hole 43A.

Moreover, when the tip of the knob 31 is made to point to index B (resistance measurement mode) and index A (temperature measurement mode using temperature sensor) successively from the position shown in Figure 14, with the further rotation of rotary switch 30 each time by an amount equivalent to one step clockwise (direction of arrow CW), the shutter board 51A does not rotate leaving the third input terminal hole in the open state and enabling various measurements including direct current voltage, alternating current voltage, resistance and temperature using only the negative common terminal hole 40A and the third input terminal hole 43A.

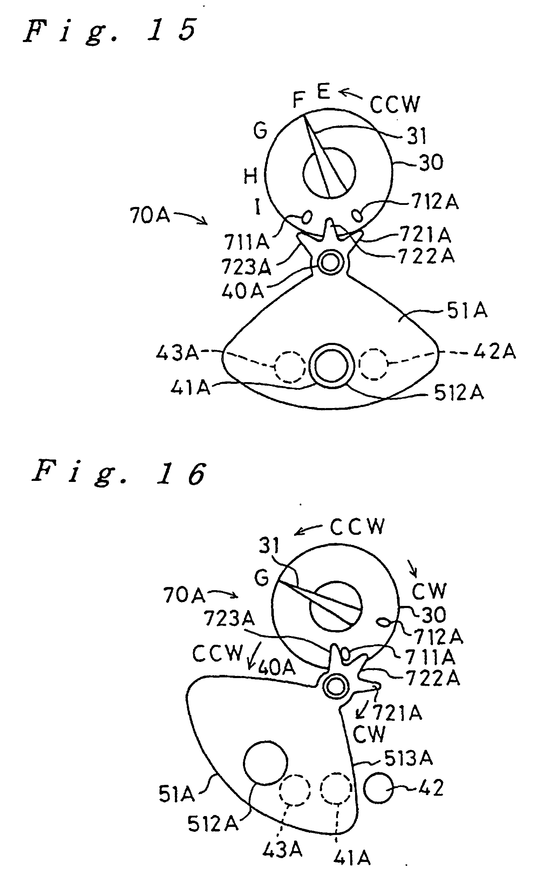

Next, when the tip of the knob 31 is made to point to index F from the position in Figure 12 with the rotation of rotary switch 30A by an amount equivalent to one step counter-clockwise (direction of arrow CCW) as shown in Figure 15, the mode switches to electric current measurement mode with the 1mA range. However, with this rotation, the first drive-side protrusion 711A does not move to the position of pushing away the second slave-side protrusion 721A. Hence the shutter board 51A does not rotate, and the round hole 512A of the shutter board 51A leaves the first input terminal hole 41 A for µA - mA range use in the open state. Thus, in the present embodiment, wide range of electric current measurement is possible using only the negative common terminal hole 40A and the first input terminal hole 41A as long as the current is small.

Next, when the tip of the knob 31 is made to point to index G from the position in Figure 15 with the further rotation of rotary switch 30A by an amount equivalent to one step counter-clockwise (direction of arrow CCW) as described in Figure 16, the mode switches to electric current measurement mode with 10A range. At this time the first drive-side protrusion 711 A pushes away the second slave-side protrusion 722A clockwise (direction of arrow CW), hence the shutter board 51A makes click and rotates by the amount equivalent of one step clockwise (direction of arrow CW). As a result, the round hole 512A of the shutter board 51A moves away from the position where the first input terminal hole 41A for µA-mA use is formed and the second input terminal hole 42A for electric current measurement with 10A range is made to be in the open state at the side edge section 513A of the shutter board 51A replacing the first input terminal hole 41 A.

Hence the measurement of large electric current becomes possible by plugging in the pin plug of the test lead into the second input terminal hole 42A.

Next, when the tip of the knob 31 is made to point to index H and index I successively from the position shown in Figure 16, with further rotation of rotary switch 30 each time by an amount equivalent to one step counter-clockwise (direction of arrow CCW), the shutter board 51A does not rotate leaving the second input terminal hole for use in measurement electric current 10A range in the open state.

Moreover, when the tip of the knob 31 is reversed to point index F again with rotation of rotary switch 30 by an amount equivalent to one step clockwise (direction of arrow CW) from the position in Figure 16, as described in Figure 15, the first drive-side protrusion 711A pushes away the third slave-side protrusion 723 counter-clockwise (direction of arrow CCW), hence, the shutter board 51A makes a click and rotates counter-clockwise (direction of arrow CCW) by the amount equivalent to one step. As a result, the first input terminal hole 41A for use in measurement of the electric current with µA - mA range returns to open state by the round hole 512A in the shutter board 51A.

### Major Efficacy of the Embodiment 4

As described above, when a measurement mode or range is selected by the switching of rotary switch 30 in the present embodiment, only the input terminal hole best fitting the condition becomes the open state, hence the pin plug of the test lead is not accidentally plugged into other input terminal hole. Therefore, no erroneous input occurs for the multimeter, preventing the failure of the multimeter, which is safe for the user.

Moreover, with the multimeter of the present embodiment, the shutter board 51A does not rotate with the rotation of rotary switch 30 as long as the first and the second drive-side protrusions 711A and 712A do not engage with the first through the third slave-side protrusions 721A, 722A, 723A in the shutter board driving mechanism 70A, hence the same input terminal hole is made to be in the open state. Hence, more than one function can be assigned to one input terminal hole while maintaining erroneous input prevention mechanism 50A operative, enabling diversified use of multimeter. In addition, the first and the second drive-side protrusions 711A, 712A are placed at locations separated from each other by a predetermined angle. Thus, in the shutter board driving mechanism 70A, positions are provided to interrupt mechanical connection of the shutter board 51A and rotary switch 30 to keep the shutter board 51A still in spite of rotation of rotary switch 30. These positions are in between the connection positions where the shutter board 51A and the rotary switch 30 are connected mechanically to interlock the rotation of rotary switch 30 and the shutter board 51A within the range of angle of rotation of the rotary switch. Hence, the present embodiment increases the degree of design freedom since more than one mode can be assigned to the first input terminal hole 41A positioned substantially in the central section in addition to the second and the third input terminal hole 42A, 43A positioned substantially in both ends out of all the input terminal holes selected by the rotary switch 30.

Moreover, in the multimeter of the present embodiment, the shutter board 51A is made to rotate with the center at negative common terminal hole 40A which is always in the open state, hence the negative common terminal hole 40A is not needed to be formed at the location outside of the range of the rotation of the shutter board 51A. Hence, the degree of design freedom increases by the amount of easing restriction on the size and the range of the rotation of the shutter board 51A. Furthermore, miniaturization is achieved by the amount of space saved by not providing the common terminal hole outside of range of the rotation.

Here, by forming the first and the second drive-side protrusions 711A, 712A in a selector board which is easily interchangeable on the rotary switch 30, the operation of the rotary switch 30 and the opening-closing pattern of the input terminal hole can be changed easily by simply replacing selector board 71 with the one having the first and the second drive-side protrusions 711A, 712A formed at different locations.

### Embodiment 5

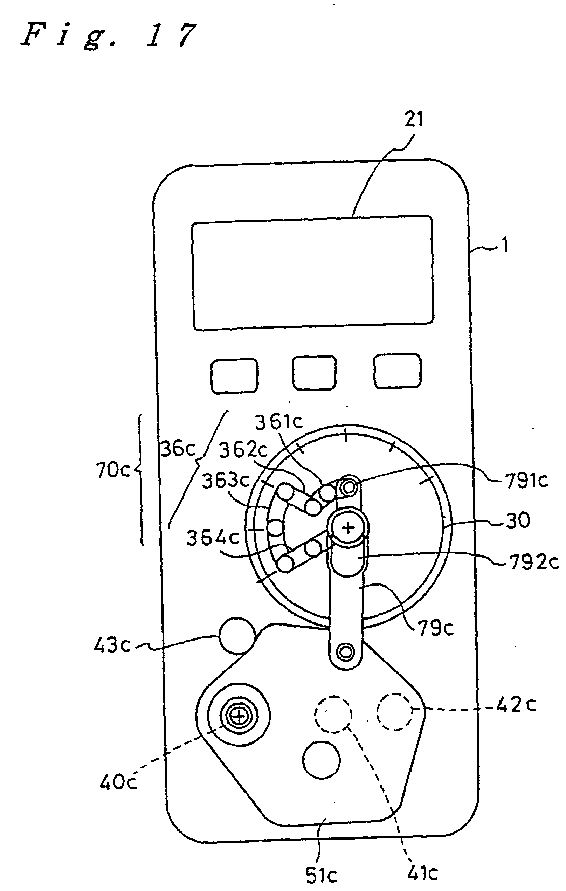

Figure 17 is a schematic top view typically showing the structure of the shutter board driving mechanism of the present embodiment. In the embodiments 5 through 7 below, the shutter board is made to rotate with the center at the common terminal hole which is in the open state in order to enable multi-functionality and the miniaturization of the shutter board driving mechanism while preventing the erroneous input of the pin plug.

In the shutter board driving mechanism 70C provided in the rotary switch of the present embodiment in Figure 17, a guide groove 36C (a cam groove) is formed on the back side of the rotary switch 30, and a pin 791C (cam pin) protruding from the lever 79C which couples the rotary switch 30 with the shutter board 51C fits inside the guide groove 36C. Here, since the rotation center axis of rotary switch 30 is placed in the elongated hole 792C formed on the lever 79C, the lever 79C can rotate around the rotation center axis and, at the same time, can slide in the radial direction of the rotary switch 30.

The guide groove 36C comprises a first guide unit 361C extending circumferentially relative to the rotary switch 30 centring at the rotation center axis, the second guide unit 362C extending from an edge section of the first guide unit 361C towards the outer perimeter of the rotary switch 30, the third guide unit 363C extending from an edge section of the second guide unit 362C along the direction of circumference, and the fourth guide unit 364C extending from an edge section of the third guide unit 363C towards the rotation center axis of the rotary switch 30. Figure 17 shows a condition wherein a pin 791 is placed in the edge section of the first guide unit 361C. Moreover, Figure 17 illustrates with a circle a locus of motion of the pin 791C in the lever 79C with each rotation of the rotary switch 30 by one step.

The shutter board 51C is able to rotate with the center of rotation at the common terminal hole 40C and the edge section of the lever 79C is coupled, free to rotate, to the section facing the shutter board 51C. Hence, in the shutter board driving mechanism 70C thus structured, when rotary switch 30 is rotated from the position shown in Figure 17, the pin 791C in the lever 79C moves inside the first through fourth guide units 361C, 362C, 363C, 364C, causing the shutter board 51C to rotate. Therefore, when measurement mode and range is selected by switching of rotary switch 30, only appropriate input terminal hole out of input terminal holes 41C, 42C, 43C is made to be in the open state by the hole 512C or the side edge section of the shutter board 51C, and the pin plug of the test lead is not accidentally plugged into other input terminal hole.

Moreover, the shutter board 51C is made to rotate with center at the negative common terminal hole 40C which is always in the open state. Therefore, it is not necessary to form a negative common terminal hole 40C outside the range of the rotation of the shutter board 51C. Hence, the degree of design freedom is increased by the amount of easing the restriction on size and the range of the rotation of the shutter board 51C. Furthermore, miniaturization is achieved by the amount of space saved by not providing the common terminal hole outside of range of the rotation.

### Embodiment 6

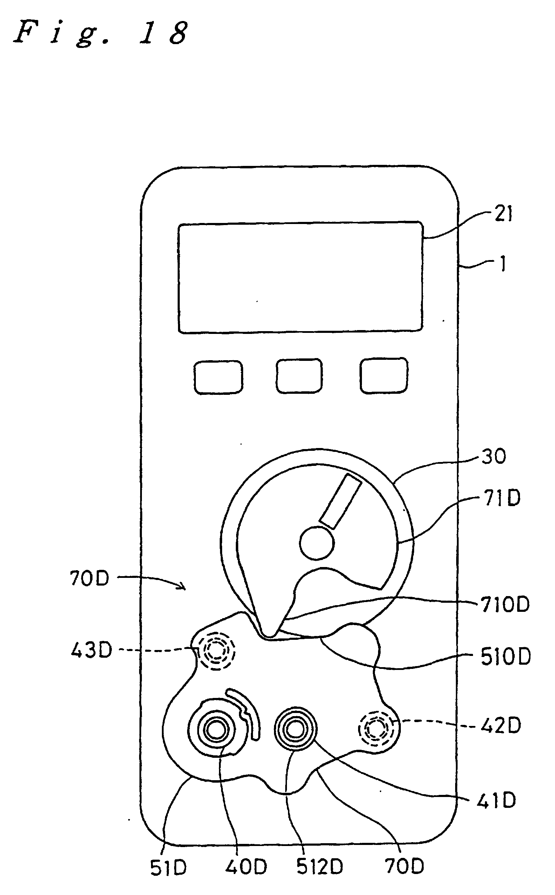

Figure 18 is a schematic top view typically showing the structure of the shutter board driving mechanism of the present embodiment. As shown in Figure 18, the shutter board driving mechanism 70D installed in the multimeter of the present embodiment has a selector 71D which rotates with rotary switch 30 as one unit in the back side of the rotary switch 30. A portion of the outer perimeter of the selector 71D is formed into a cam 710D having a specific mountain-valley shape. On the other hand, the shutter board 51D is able to rotate with center at common terminal hole 40D and a mountain-valley shape 510D, similar to the cam 710D for the selector 71D, is formed in the outer perimeter of the shutter board 51D to rotate the shutter board 51D. A spring (not shown) holds the shutter board 51D in contact with the cam 710D.

Even in the shutter board driving mechanism 70D thus structured, the shutter board 51D rotates with the rotation of the selector 71D when the measurement mode or the range is switched by rotating the rotary switch 30, or the shutter board 51D may remain in place, depending on the specific mountain-valley shape selected for the cam 710D and outer perimeter of the shutter board 51D. As a result, only an appropriate input terminal hole out of the first through the third input terminal hole 41D, 41D, 43D becomes the open state from the hole 512D or the side edge section of the shutter board 51D and the pin plug of the test lead is not accidentally plugged into other input terminal hole.

Moreover, the shutter board 51D is made to rotate with the center at the negative common terminal hole 40D which is always in the open state. Hence the negative common terminal hole 40D need not be formed at the location outside of the range of the rotation of the shutter board 51D. Hence, the degree of design freedom increases by the amount of easing restriction on the size and the range of the rotation of the shutter board 51D. Furthermore, miniaturization of the multimeter is achieved by the amount of space saved by not providing the negative common terminal hole outside of range of the rotation.

### Embodiment 7

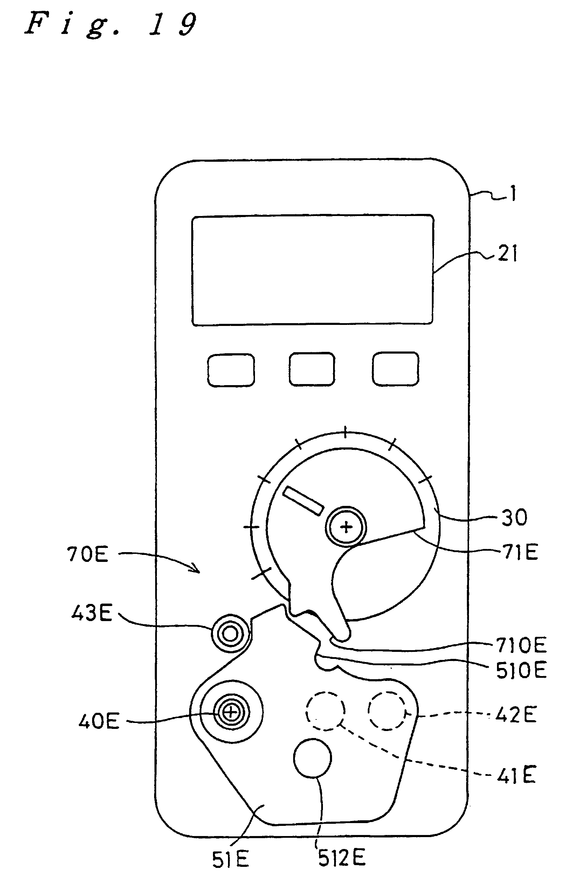

Figure 19 is a schematic top view typically describing the structure of the shutter board driving mechanism of the present embodiment. As Figure 19 describes, the shutter board driving mechanism 70E provided in the multimeter of the present embodiment also has the selector 71E in the back side of the rotary switch 30 which rotates with the rotary switch 30 as one unit. A portion of the outer perimeter of the selector 71E is formed into cam 710E having a specific mountain-valley shape. On the other hand, the shutter board 51E is able to rotate with center at common terminal hole 40D and a mountain-valley shape 510E, similar to the cam 710E for the selector 71E, is formed in the outer perimeter of the shutter board 51E to rotate the shutter board 51E. A spring (not shown) holds the shutter board 51E in contact with the cam 710E.

Even in the shutter board driving mechanism 70E thus structured, the shutter board 51E may rotate with the rotation of the selector 71E when the measurement mode or the range is switched by rotating the rotary switch 30, or the shutter board 51E may remain in place, depending on the specific mountain-valley shapes selected for the cam 710E and outer perimiter of the shutter board 51E. As a result, only an appropriate input terminal hole out of the first through the third input terminal hole 41E, 42E, 43E becomes the open state from the hole 512E or the side edge section of the shutter board 51E and the pin plug of the test lead is not accidentally plugged into other input terminal hole.

Moreover, the shutter board 51E is made to rotate with the center at the negative common terminal hole 40E which is always in the open state. Hence the negative common terminal hole 40E is not needed to be formed at the location outside of the range of the rotation of the shutter board 51E. Hence, the degree of design freedom increases by the amount of easing restriction on the size and the range of the rotation of the shutter board 51E. Furthermore, miniaturization of multimeter is achieved by the amount of space saved by not providing the negative common terminal hole outside of range of the rotation.

### Other Embodiments

Moreover, in the above embodiments, explanation is made with common terminal hole used as a negative terminal but it is obvious that common terminal hole can also be used as a positive terminal.

### Efficacy of Invention

As described above, in the multimeter of the present invention, when the measurement mode or the range is switched by rotating the rotary switch 30, only an appropriate input terminal hole is made to be in the open state and the pin plug of the test lead is not accidentally plugged into other input terminal hole, which is also safe for the user.

Moreover, with the rotation of the rotary switch, the shutter board becomes connected mechanically to the rotary switch, the connection becomes interrupted, and again becomes mechanically connected to the rotary switch, hence, more than one mode can be assigned, in practice, to the input terminal hole located at central section, resulting in a high degree of design freedom.

In the shutter board driving mechanism, if the rotation of rotary switch is made to be transmitted to shutter board by at least two drive-side protrusions which rotate with the rotary switch as one unit, even when the rotary switch is made to rotate, the same selection terminal hole remains in the open state as long as the driver-side protrusions do not operate. Hence, complex mechanism is not needed in structuring multimeter in such a manner that one selection terminal hole has more than one functions, enabling miniaturization and multi-functionality of the multimeter. In such a case, if drive-side protrusions are formed in a selector member freely interchangeable on the rotary switch, the corresponding relationship between the operation of the rotary switch and the opening and closing operation of the selection terminal hole by shutter board can easily be changed by simply replacing the selector member with one having drive-side protrusions at different positions.

With the present invention, if the shutter board is made to rotate with the center at the location where common terminal hole is formed, the shutter board rotates with the center at common terminal hole which is always left in the open state, hence the common terminal hole is not needed to be formed at the location outside of the range of the rotation of the shutter board. Hence, the degree of design freedom increases by the amount of easing restriction on the size and the range of the rotation of the shutter board. Furthermore, miniaturization by the amount equivalent of placing the common terminal hole within the range of rotation is achieved.

In the present invention, if one of the plurality of selection terminal holes is made to be in the open state by protruding from the side edge section of the shutter board, the selection terminal holes can be placed at an arbitrary radial distance from the center of rotation of shutter board as long as the side edge section of shutter board appears and disappears at that position. Hence the degree of design freedom is increased for the location of selection terminal holes, improving the usability and the design characteristics.
The aforegoing description has been given by way of example only and it will be appreciated by a person skilled in the art that modifications can be made without departing from the scope of the present invention as defined in the appended claims.

## Claims

1. A multimeter (1) with an erroneous input prevention mechanism (50) comprising a rotary switch (30) for rotation in a clockwise or counter-clockwise direction to select a measuring function, a common terminal hole (40) to plug in a test lead pin plug, a plurality of selection holes (41, 42, 43) separate from the common terminal hole, a shutter board (51) rotating in predetermined range of angles based on the rotation operation of the rotary switch (30) while leaving the common terminal hole (40) in the open state and opening one of the selection terminal holes out of the plurality of selection terminal holes (41, 42, 43) while interrupting other selection holes, and a shutter board driving mechanism (70) to drive the rotation of the shutter board (51) by transmitting rotational motion from the rotary switch (30) to the shutter board (51), **characterised in that** the shutter board driving mechanism (70) is provided, for rotational operation of the rotary switch (30) in each of the clockwise and the counter-clockwise directions, with at least two connection positions within the range of rotation of the rotary switch (30) to mechanically connect the shutter board (51) and the rotary switch (30), thereby interlocking rotation of the shutter board (51) with rotation of the rotary switch (30), and is further provided with interrupting positions between the connection positions to interrupt the mechanical connection of the shutter board (51) and rotary switch (30) while keeping the shutter board (51) stopped regardless of the rotation of the rotary switch (30).

2. A multimeter with an erroneous input prevention mechanism according to claim 1 **characterised in that** the shutter board driving mechanism (70) is provided with at least two drive-side protrusions (711, 712) at positions separated by a predetermined angle to transmit the rotational operation of the rotary switch (30) to the shutter board (51) by rotating the shutter board (51) with the rotary switch (30) as one unit wherein the connection position and the interrupting position are determined by the positions of the drive-side protrusions (711, 712).

3. A multimeter with an erroneous input prevention mechanism according to claim 2 **characterised in that** the shutter board driving mechanism (70) is provided with a slave member (72) which transmits rotational driving power from the drive-side protrusions (711, 712) to the shutter board (51), and wherein the slave member (72) has a slave-side protrusion (721, 722) and transmits the rotational driving power to the shutter board (51) through the slave-side protrusions (721, 722).

4. A multimeter with an erroneous input prevention mechanism according to claim 2 or Claim 3 **characterised in that** the drive-side protrusions (711, 712) are formed in a selector member (71) which is freely interchangeable on the rotary switch (30).

5. A multimeter with an erroneous input prevention mechanism according to any preceding claim **characterised in that** the shutter board (51) is structured to rotate with the center of rotation at the position where the common terminal hole is formed.

6. A multimeter with an erroneous input prevention mechanism according to any preceding claim, **characterised in that** the plurality of selection terminal holes (41, 42, 43) comprise first and second selection terminal holes (41, 42) formed at two locations in substantially the same angular direction but different radial distances from the common terminal hole (40), the first selection terminal hole (41) becomes the open state by the matching of a hole (512) formed on the shutter board while becoming the interruption state by mismatching of the hole (512), and the second selection terminal hole (42) becomes the interruption state by being covered by one of the side edges (513) of the shutter board (51) while becoming open state by protruding out of the side edge (513).

7. A multimeter with an erroneous input prevention mechanism according to Claim 6, **characterised in that** the plurality of selection terminal holes (41, 42, 43) further comprise a third selection terminal hole (43) formed at a third location at a different angular direction to the first and the second selection terminal holes (41, 42) from the common terminal hole (40), the third selection terminal hole (43) becoming the interrupt state by being covered by the other side edge (515) of the shutter board (51) while becoming the open state by protruding out of the other side edge (515).

## Patentansprüche

1. Vielfachmessgerät (1) mit einer Falscheingabe-Verhinderungseinrichtung (50), umfassend: einen Drehschalter (30) für eine Drehung im Uhrzeigersinn oder Gegenuhrzeigersinn, um eine Messfunktion auszuwählen; ein Masseanschlussloch (40) zum Einstecken eines Prüfleitungsstiftsteckers; mehreren vom Masseanschlussloch getrennten Auswahllöchern (41, 42, 43); einer Verschlussplatte (51), die sich im vorgegebenen Winkelbereich auf der Grundlage der Drehoperation des Drehschalters (30) dreht, wobei das Masseanschlussloch (40) im offenen Zustand belassen wird und eines der Auswahlanschlusslöcher der mehreren Auswahlanschlusslöcher (41, 42, 43) geöffnet wird, während die anderen Auswahllöcher unterbrochen werden; und eine Verschlussplattenantriebseinrichtung (70) zum Antreiben der Drehung der Verschlussplatte (51) durch Übertragen der Drehbewegung vom Drehschalter (30) auf die Verschlussplatte (51 ); **dadurch gekennzeichnet, dass** die Verschlussplattenantriebseinrichtung (70) für eine Drehbetätigung des Drehschalters (30) im Uhrzeigersinn und im Gegenuhrzeigersinn mit wenigstens zwei Verbindungspositionen innerhalb des Drehbereiches des Drehschalters (30) versehen ist, um die Verschlussplatte (51) und den Drehschalter (30) mechanisch zu verbinden, um somit die Drehung der Verschlussplatte (51) mit der Drehung des Drehschalters (30) zu koppeln, und ferner mit Unterbrechungspositionen zwischen den Verbindungspositionen versehen ist um die mechanische Verbindung der Verschlussplatte (51) und des Drehschalters (30) zu unterbrechen, während die Verschlussplatte (51) unabhängig von der Drehung des Drehschalters (30) stillgehalten wird.

2. Vielfachmessgerät mit einer Falscheingabe-Verhinderungseinrichtung nach Anspruch 1, **dadurch gekennzeichnet, dass** die Verschlussplattenantriebseinrichtung (70) mit wenigstens zwei antriebsseitigen Vorsprüngen (711, 712) an Positionen versehen ist, die durch einen vorgegebenen Winkel getrennt sind, um die Drehoperation des Drehschalters (30) auf die Verschlussplatte (51) zu übertragen, indem die Verschlussplatte (51) mit dem Drehschalter (30) als eine Einheit gedreht wird, wobei die Verbindungsposition und die Unterbrechungsposition durch die Positionen der antriebsseitigen Vorsprünge (711, 712) bestimmt werden.

3. Vielfachmessgerät mit einer Falscheingabe-Verhinderungseinrichtung nach Anspruch 2, **dadurch gekennzeichnet, dass** die Verschlussplattenantriebseinrichtung (70) mit einem untergeordneten Element (72) versehen ist, das die Drehantriebskraft von den antriebsseitigen Vorsprüngen (711, 712) auf die Verschlussplatte (51) überträgt, wobei das untergeordnete Element (72) untergeordnete Vorsprünge (721, 722) aufweist und die Drehantriebskraft über die untergeordneten Vorsprünge (721, 722) auf die Verschlussplatte (51) überträgt.

4. Vielfachmessgerät mit einer Falscheingabe-Verhinderungseinrichtung nach Anspruch 2 oder Anspruch 3, **dadurch gekennzeichnet, dass** die antriebsseitigen Vorsprünge (711, 712) in einem Auswählerelement (71) ausgebildet sind, das auf dem Drehschalter (30) frei austauschbar ist.

5. Vielfachmessgerät mit einer Falscheingabe-Verhinderungseinrichtung nach irgendeinem der vorangehenden Ansprüche, **dadurch gekennzeichnet, dass** die Verschlussplatte (51) so aufgebaut ist, dass sie mit dem Rotationszentrum an der Position, an der das Masseanschlussloch ausgebildet ist, rotiert.

6. Vielfachmessgerät mit einer Falscheingabe-Verhinderungseinrichtung nach irgendeinem der vorangehenden Ansprüche, **dadurch gekennzeichnet, dass** die mehreren Auswahlanschlusslöcher (41, 42, 43) erste und zweite Auswahlanschlusslöcher (41, 42) umfassen, die an zwei Stellen im Wesentlichen in der gleichen Winkelrichtung jedoch mit verschiedenen radialen Abständen vom Masseanschlussloch (40) ausgebildet sind, wobei das erste Auswahlanschlussloch (41) durch die Ausrichtung eines Loches (512), das auf der Verschlussplatte ausgebildet ist, in den offenen Zustand versetzt wird, während es durch die Falschausrichtung des Loches (512) in den Unterbrechungszustand versetzt wird, und wobei das zweite Auswahlanschlussloch (42) in den Unterbrechungszustand versetzt wird, indem es durch eine der Seitenkanten (513) der Verschlussplatte (51) abgedeckt wird, während es in den offenen Zustand versetzt wird, indem die Seitenkante (513) hervorgeschoben wird.

7. Vielfachmessgerät mit einer Falscheingabe-Verhinderungseinrichtung nach Anspruch 6, **dadurch gekennzeichnet, dass** die mehreren Auswahlanschlüsse (41, 42, 43) ferner ein drittes Auswahlanschlussloch (43) umfassen, das an einer dritten Stelle in einer verschiedenen Winkelrichtung bezüglich der ersten und zweiten Auswahlanschlusslöcher (41, 42), ausgehend vom Masseanschlussloch (40), ausgebildet ist, wobei das dritte Auswahlanschlussloch (43) in den Unterbrechungszustand versetzt wird, indem es durch die andere Seitenkante (515) der Verschlussplatte (51) abgedeckt wird, während es in den offenen Zustand versetzt wird, indem die andere Seitenkante (515) hervorgeschoben wird.

## Revendications

1. Multimètre (1) avec un mécanisme de prévention d'entrée erronée (50) comprenant un commutateur rotatif (30) pour une rotation dans le sens des aiguilles d'une montre ou dans le sens inverse des aiguilles d'une montre pour sélectionner une fonction de mesure, un trou de connexion commun (40) pour enficher une fiche goupille de cordon d'essai, une pluralité de trous de sélection (41, 42, 43) séparés du trou de connexion commun, un tableau obturateur (51) pivotant sur une étendue prédéterminée d'angles basés sur l'action de rotation du commutateur rotatif (30) en laissant le trou de connexion commun (40) à l'état ouvert et en ouvrant un des trous de connexion de sélection parmi la pluralité de trous de connexion de sélection (41, 42, 43) en interrompant les autres trous de sélection, et un mécanisme de commande de tableau obturateur (70) pour commander la rotation du tableau obturateur (51) en transmettant un mouvement rotatoire du commutateur rotatif (30) au tableau obturateur (51), **caractérisé en ce que** le mécanisme de commande de tableau obturateur (70) est fourni, pour une action rotatoire du commutateur rotatif (30) dans chacun des sens des aiguilles d'une montre et inverse des aiguilles d'une montre, avec au moins deux positions de connexion dans les limites de l'étendue de rotation du commutateur rotatif (30) pour connecter de manière mécanique le tableau obturateur (51) et le commutateur rotatif (30), moyennant quoi une rotation de verrouillage du tableau obturateur (51) avec une rotation du commutateur rotatif (30), et est fourni en outre avec des positions d'interruption entre les positions de connexion pour interrompre la connexion mécanique du tableau obturateur (51) et du commutateur rotatif (30) en gardant le tableau obturateur (51) arrêté sans tenir compte de la rotation du commutateur rotatif (30).

2. Multimètre avec un mécanisme de prévention d'entrée erronée selon la revendication 1, **caractérisé en ce que** le mécanisme de commande de tableau obturateur (70) est fourni avec au moins deux saillies côté commande (711, 712) à des positions séparées par un angle prédéterminé pour transmettre l'action rotatoire du commutateur rotatif (30) au tableau obturateur (51) en faisant pivoter le tableau obturateur (51) avec le commutateur rotatif (30) comme une unité dans laquelle la position de connexion et la position d'interruption sont déterminées par les positions des saillies côté commande (711, 712).

3. Multimètre avec un mécanisme de prévention d'entrée erronée selon la revendication 2, **caractérisé en ce que** le mécanisme de commande de tableau obturateur (70) est muni d'un élément esclave (72) qui transmet une puissance de commande rotatoire des saillies côté commande (711, 712) au tableau obturateur (51), et dans lequel l'élément esclave (72) a une saillie côté esclave (721, 722) et transmet la puissance de commande rotatoire au tableau obturateur (51) à travers les saillies côté esclave (721, 722).

4. Multimètre avec un mécanisme de prévention d'entrée erronée selon la revendication 2 ou la revendication 3, **caractérisé en ce que** les saillies côté commande (711, 712) sont formées dans un élément sélecteur (71) qui est de manière libre amovible sur le commutateur rotatif (30).

5. Multimètre avec un mécanisme de prévention d'entrée erronée selon l'une quelconque des revendications précédentes, **caractérisé en ce que** le tableau obturateur (51) est structuré pour pivoter avec le centre de rotation à la position où le trou de connexion commun est formé.

6. Multimètre avec un mécanisme de prévention d'entrée erronée selon l'une quelconque des revendications précédentes, **caractérisé en ce que** la pluralité de trous de connexion de sélection (41, 42, 43) comprend des premier et deuxième trous de connexion de sélection (41, 42) formés à deux emplacements sensiblement dans la même direction angulaire mais de distances radiales différentes du trou de connexion commun (40), le premier trou de connexion de sélection (41) devient l'état ouvert par l'adaptation d'un trou (512) formé sur le tableau obturateur en devenant l'état d'interruption par une désadaptation du trou (512), et le deuxième trou de connexion de sélection (42) devient l'état d'interruption en étant recouvert par un des bords latéraux (513) du tableau obturateur (51) en devenant l'état ouvert en poussant sur le bord latéral (513).

7. Multimètre avec un mécanisme de prévention d'entrée erronée selon la revendication 6, **caractérisé en ce que** la pluralité de trous de connexion de sélection (41, 42, 43) comprend en outre un troisième trou de connexion de sélection (43) formé à un troisième emplacement à une direction angulaire différente au premier trou et au deuxième trou de connexion de sélection (41, 42) du trou de connexion commun (40), le troisième trou de connexion de sélection (43) devenant l'état d'interruption en étant recouvert par l'autre bord latéral (515) du tableau obturateur (51) en devenant l'état ouvert en poussant sur l'autre bord latéral (515).
